# EUROPEAN PATENT APPLICATION

(11) **EP 4 207 959 A1**
(43) Date of publication of application: **05.07.2023**
(21) Application number: 22209942.6
(22) Date of filing: 28.11.2022
(51) Int. Cl.: H05K 5/02, H05K 9/00

(54) **A CABLE ARRANGING ELEMENT FOR HOUSEHOLD APPLIANCES AND A METHOD THEREOF**

(30) Priority: 29.12.2021 TR 202121507
(71) Applicant: BSH Hausgeräte GmbH, 81739 München (DE)
(72) Inventor: Köroglu, Ismail, Istanbul (TR); Özsoy, Melih, 34760 ISTANBUL (TR)

(57) **Abstract**

The invention relates to a household appliance (1), particularly a cooling device, comprising a heat-insulating housing (2) having an outer wall (23) facing outside, a cabinet (4) enclosing an internal space (5), a control unit (22) for controlling at least one operation in the internal space (5) by means of at least one first electrical cable (6) through which an alternating current flows, and at least one second electrical cable (7) through which a direct current flows, In the invention, a cable arranging element (21) is provided on a wall surface (11) of the cabinet (4) facing the outer wall (23) in such a way that the first electrical cable (6) and the second electrical cable (7) are being in a predetermined distance (D). The present invention also relates to a method for arranging two electrical cables (6, 7) of the household appliance (1) in a predetermined distance (D) by means of a cable arranging element (21).

## Description

### Technical Field

The present invention relates to a household appliance, particularly a cooling appliance according to the preamble of claim 1 and a method thereof.

### Prior Art

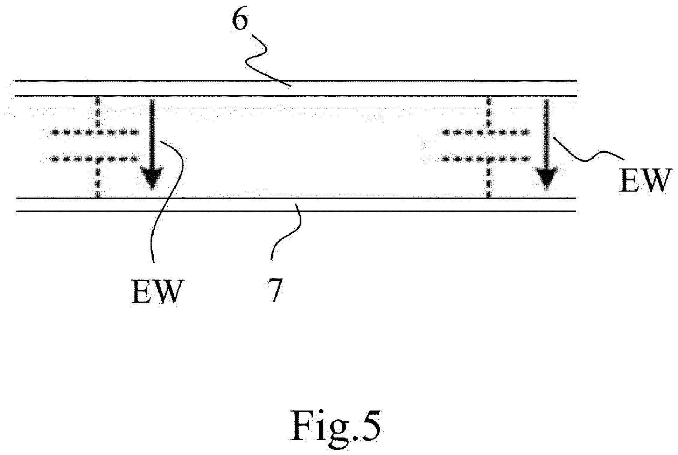

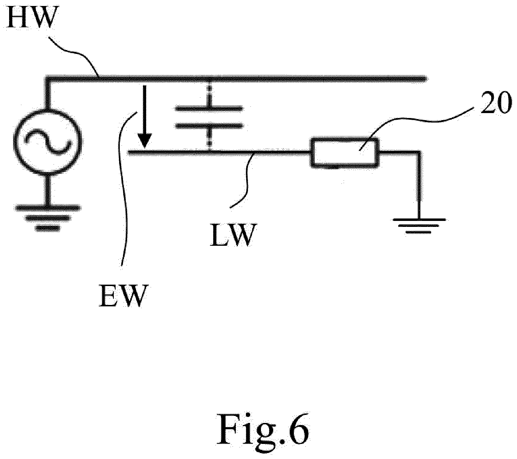

Electrical appliances, such as household appliances (ie. cooling appliances, ovens, washing machines, dishwashers) must comply with statutory limit values with regard to their electromagnetic influences on other component. The components or the modules they contain, which emit electromagnetic waves, are therefore tested for their electromagnetic compatibility (EMC). This is to ensure that the operation of a particular device does not cause any malfunctions in other components. Household appliances comprise control units which control the operations of the components via electrical cables. Electrical cables extends from the control units to the relative components. Such electrical cables are the electrical cables through which an alternating current flows and the electrical cables through which a direct current flows. The electrical cables through which the alternating current flows, provide noisy or pulsed lines. The electrical cables through which the direct current flows, provide victim or signal line. In more details, the electrical cables through which an alternating current flows radiates electromagnetic waves towards the electrical cable through which a direct current flows. This situation effect the electrical cable through which a direct current flows negatively. For example, the operations of the electrical components (ie. a damper, a fan motor) can be effected negatively. This negative effects can also be overvoltage or short circuit (see Figs. 5 and 6).

The document numbered CN105636424 A provides a mechanical structure for lowering EMC (Electro Magnetic Compatibility). The mechanical structure comprises a current-conducting plate and a binding unit, wherein the current-conducting plate is provided with two mechanical piercings side by side, and an interval between the two mechanical piercings is the width of a set of all bundles which need to pass through the current-conducting plate. Through the current-conducting plate and the binding unit, CE (Conducted Emission) and RE (Radiated Emission) on each bundle form a ground loop with the current-conducting plate nearby so as to annihilate, and therefore, the EMC actual measurement value of a bundle input end is greatly lowered. Therefore, under a situation that the use of a filter, a magnetic ring and shielding materials is reduced, the research and development and production cost of a product is effectively lowered, the product is simple, is compact in layout and is stable and reliable in performance, effectively simplifies a product assembling technology and lowers operation requirements on assembling personnel.

The invention provides an additional improvement, an additional advantage or an alternative to the prior art.

### Brief Description of the Invention

The object of the invention is to provide a household appliance, particularly a cooling appliance having an improved electromagnetic compatibility (EMC).

Another object of the invention is to provide a method for arranging two electrical cables of a household having lower labor costs.

In order to achieve the above-mentioned objects, the invention is a household appliance, particularly a cooling appliance, comprising a heat-insulating housing having an outer wall facing outside, a cabinet enclosing an internal space, a control unit for controlling at least one operation in the internal space by means of at least one first electrical cable through which an alternating current flows, and at least one second electrical cable through which a direct current flows. In the invention, a cable arranging element is provided on a wall surface of the cabinet facing the outer wall in such a way that the first electrical cable and the second electrical cable are being in a predetermined distance. Thus, electrical cable through which the alternating current flows radiates lower electromagnetic waves towards the electrical cable through which the direct current flows. Therefore, electrical components (ie. dampers, fan motors) are prevented from being negatively affected by this electromagnetic waves, and the household appliance having an improved electromagnetic compatibility (EMC), is ensured.

Here, the electrical cables can be any kind of cables provided between the control unit and the respective electrical component.

In a possible embodiment of the invention, the wall surface is being a surface of a rear wall of the cabinet which is at an opposite side of a front opening providing access to the internal space. Thus, both the first electrical cable and the second electrical cable extend on the rear surface along the cabinet. Therefore, the amount of electrical cable usage is reduced and accordingly, the production costs of the household appliance is reduced.

In a possible embodiment of the invention, the cable arranging element comprises a body part and two connection members provided on the body part mutually. Thus, an arrangement is provided for keeping the relevant electrical cables in the predetermined distance.

Here, the connection members can be any kind of members for keeping the electrical cables in the predetermined distance. The connection members can be any kind of clamping members.

In a possible embodiment of the invention, an adhesive element is provided so as to connect each of the connection members to the body part. Thus, each of the connection members connect to the body part. Therefore, possible undesirable separations between the connection members and the body part are prevented.

In a possible embodiment of the invention, the adhesive element is being a double-sided tape provided between the respective portions of the body part and the respective connection members. Thus, each of the connection members connect to the body part. Therefore, possible undesirable separations between the connection members and the body part are prevented.

In a possible embodiment of the invention, each of the connection members comprise a bendable portion which can be movable between a first position in which the each bendable portions extend in a direction away from the body part, and a second position in which the bendable portions pass through the respective receiving portions of the respective connection members so as to provide a loop portion through which the respective electrical cables pass. Thus, each respective electrical cables are provided in the predetermined distance. Therefore, the electrical cables are prevented from coming closer to each other according to the predetermined distance.

Here, more than one electrical cables (ie. cable bundles) can pass through the each of loop portions of the bendable portions.

Here, the electrical cables can pass through the respective loop portions in a loose manner or in a tightened manner.

In a possible embodiment of the invention, each of the connection members have a knurled portion provided on the bendable portions configured so that the respective bendable portions lock to the respective receiving portions. Thus, suitable positioning of the each respective electrical cables is ensured and possible undesirable separations are prevented.

In a possible embodiment of the invention, each of the receiving portions are provided on a vicinity of the respective adhesive elements. Thus, the adhesive elements are provided on the area closer to the area where external forces exerted by the assembler in order to obtain the loop portions for the respective electrical cable.

In a possible embodiment of the invention, the predetermined distance provided between the first electrical cable and the second electrical cable is at least 7 mm, preferably at least 10 mm. Thus, an optimized predetermined distance for the improved electromagnetic compatibility (EMC) is provided.

In a possible embodiment of the invention, a plurality of cable arranging elements are provided between the electrical cables, intermittently with each other on the cabinet. Thus, the predetermined distance between the electrical cables is preserved along the cabinet of the household appliance.

In order to achieve the above-mentioned objects, the invention is a method for arranging two electrical cables of a household appliance in a predetermined distance by means of a cable arranging element. The method comprises the steps of:
- providing a cable arranging element having a body part and two connection members by adhering each of the connection members to the respective portions of the body part,
- laying the first electrical cable onto the first connection member,
- laying the second electrical cable onto the second connection member,
- moving the bendable portions of each connection members towards the respective receiving portions in such a way that the bendable portions passes through the respective receiving portions in order to provide loop portions through which the respective electrical cables pass,
- stopping the movement of the bendable portions when the loop portions are provided for each respective electrical cables.

Thus, electrical cable through which the alternating current flows radiates lower electromagnetic waves towards the electrical cable through which the direct current flows. Therefore, electrical components (ie. dampers, fan motors) are prevented from being negatively affected by this electromagnetic waves, and the household appliance having an improved electromagnetic compatibility (EMC), is ensured. Also a method for arranging two electrical cables of a household appliance in a predetermined distance is provided with a lower labor costs.

In this context, with the indications "top", "bottom", "front", "rear", "horizontal", "vertical", "upward", "downward", "inner", "outer", "inward", "outward" etc. the positions and orientations given for intended use and intended arrangement of the household appliance and for a user then standing in front of the household appliance in a closed position and viewing in the direction of the appliance are indicated.

Each possible embodiment disclosed in this text can be combined with the other possible embodiments disclosed in this text if there is no any technical constraint.

### Explanation of Figures

The figures, whose brief explanations are herewith provided, are solely intended for providing
a better understanding of the present invention and are as such not intended to define the scope of protection or the context in which said scope is to be interpreted in the absence of the description.
Fig. 1 is a representative isometric view of the exemplary household appliance, ie. cooling appliance having a cabinet.
Fig. 2 is a representative isometric view of the cabinet of the household appliance where the subject-matter cable arranging element is in the second position.
Fig. 3 is a representative isometric view of the subject-matter cable arranging element in the first position.
Fig. 4 is a front view of the subject-matter cable arranging element in the first position.
Fig. 5 is an electrical schema which shows the radiation of the electromagnetic waves between the electrical cables.
Fig. 6 is an another electrical schema which shows affecting of the electromagnetic waves to an electrical component.

### Detailed Description of the Figures

In this detailed description, the subject matter is explained with references to examples without forming any restrictive effect only in order to make the subject more understandable. According to this, in the detailed explanation below, the subject-matter cable arranging element (21) is explained to be applied to a cooling appliance, such as a refrigerator. However, the subject-matter cable arranging element (21) can be applied any kind of household appliances (1) such as ovens, washing machines, dishwashers.

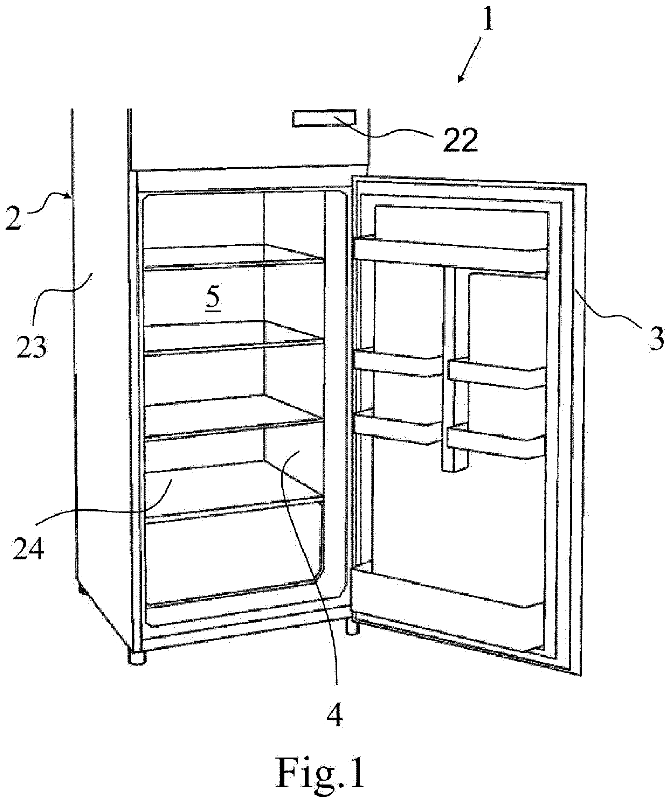

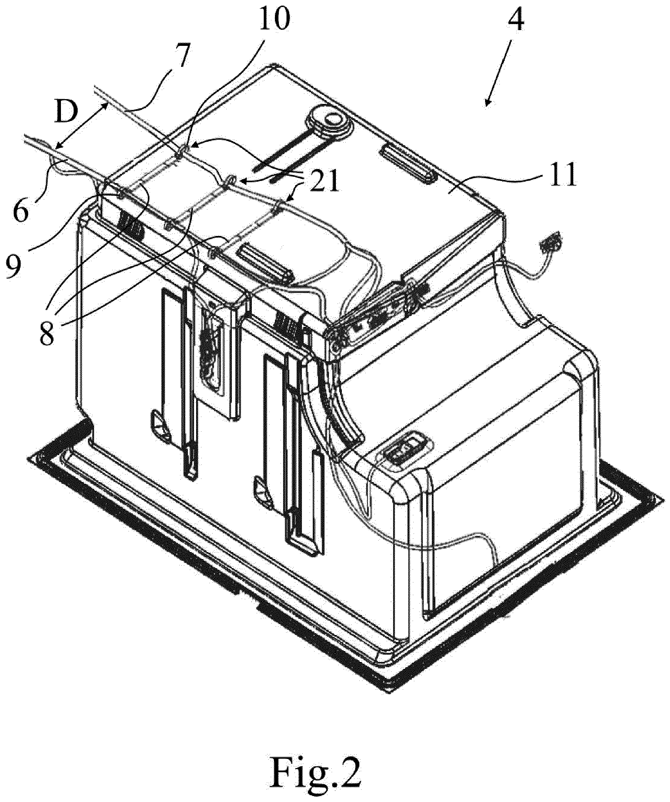

Referring to Fig. 1, the exemplary household appliance (1) is a cooling appliance, particularly a refrigerator. The cooling appliance comprises a heat-insulating housing (2) having an outer wall (23) facing outside. A cabinet (4) is surrounded by the heat-insulating housing (2). In more details, there is an insulation element (not shown), such as a polyurethane material is provided between the cabinet (4) and the outer wall (23). The cabinet (4) encloses an internal space (5) in which the foodstuffs to be cooled can be placed. There is a front opening (24) provided on a front side of the cooling appliance. At least one door (3) is hinged to the heat-insulating housing (2). The door (3) is pivotably movable between an open position in which it provides to access to the internal space (5) and a closed position in which it covers the front opening (24). A control unit (22) is provided for controlling at least one operation in internal space (5). In order to control a cooling operation of the cooling appliance, the control unit (22) controls the operation of the components (ie. fan motor, compressor, damper) of the appliance. The control unit (22) controls at least one operation in the internal space (5) by means of at least one electrical cable. As can be seen in Fig.2, there is at least one first electrical cable (6) through which an alternating current flows, and there is at least one second electrical cable (7) through which a direct current flows. In more details, the first electrical cable (6) is being an AC (alternating current) cable and the second electrical cable (7) is being a DC (direct current) cable. In a possible embodiment of the invention, a cable arranging element (21) is provided on a wall surface (11) of the cabinet (4) facing the outer wall (23) in such a way that the first electrical cable (6) and the second electrical cable (7) are being in a predetermined distance (D). Thus, the first electrical cable (6) radiates lower electromagnetic waves towards the second electrical cable (7). The predetermined distance (D) which is provided between the first electrical cable (6) and the second electrical cable (7), is at least 7 mm, preferably at least 10 mm. Thus, an optimized predetermined distance (D) for the improved electromagnetic compatibility (EMC) is provided. The maximum value of the predetermined distance (D) can vary according to a width of the cabinet (4) and the appliance. As can be seen in Fig.2, the cable arranging element (21) is provided on a surface of a rear wall of the cabinet (4) which is at an opposite side of the front opening (24) providing access to the internal space (5). In a possible embodiment, a plurality of cable arranging elements (21) are provided between the electrical cables (6, 7), intermittently with each other on the cabinet (4). As an example, in Fig.2, there are three identical cable arranging elements (21). Thus, the predetermined distance (D) between the electrical cables (6, 7) is preserved along the cabinet (4) of the cooling appliance. The cable arranging element (21) comprises a body part (8) and two connection members (9, 10) provided on the body part (8) mutually. After the cable arranging elements (21) are arranged on the rear wall of the cabinet (4), then a foaming process can be started in order to fill the gap between the outer wall (23) of the thermally-insulating housing () and the rear wall of the cabinet (4).

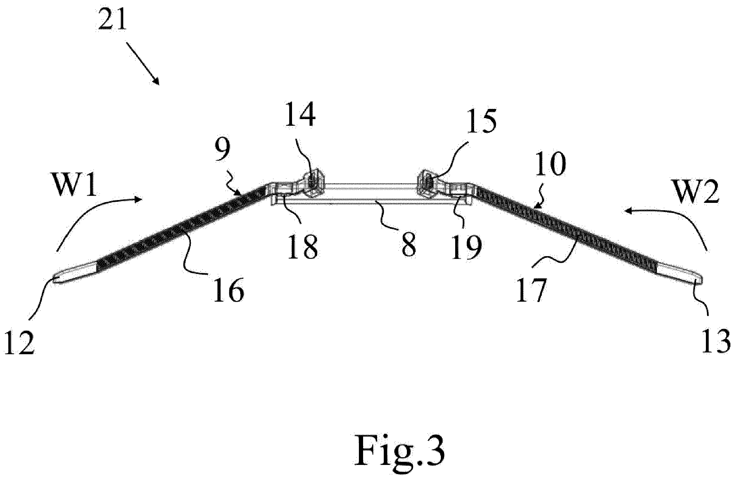

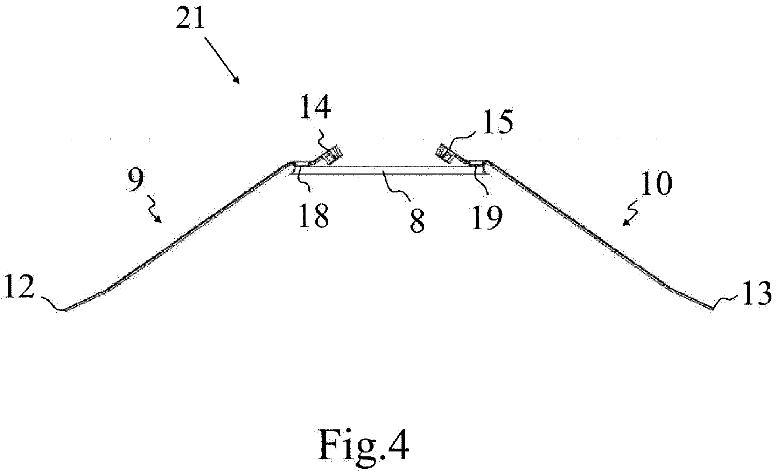

Fig.3 represents an isometric view of the subject-matter cable arranging element (21) and Fig.4 represents a front view of the subject-matter cable arranging element (21). Each of the connection members (9, 10) comprise bendable portions (12, 13) which can be movable between a first position in which the bendable portions (12, 13) extend in a direction away from the body part (8), and a second position in which the bendable portions (12, 13) pass through the respective receiving portions (14, 15) of the respective connection members (9, 10) so as to provide a loop portion through which the respective electrical cables (6, 7) pass. Each of the loop portions are the portion which provide a circle through which the respective electrical cables (6, 7) pass. Fig.3 and Fig.4 show the first position of the subject-matter cable arranging element (21). In the first position, the bendable portions (12, 13) of each connection members (9, 10) extend in a direction away from the body part (8). In other words, in the first position, the bendable portions (12, 13) extend longitudinally. Each of the connection members (9, 10) have a free end away from the body part (8). Moreover, each of the connection members (9, 10) comprises a receiving portion (14, 15) on an opposite side of the free end. An adhesive element (18, 19) is provided so as to connect each of the connection members (9, 10) to the body part (8). The body part (8) can be made from a metal material or a plastic material. Preferably, the body part (8) is made from acrylonitrile butadiene styrene (ABS). In a possible embodiment, the adhesive element (18, 19) is being a double-sided tape provided between the respective portions of the body part (8) and the respective connection members (9, 10). Said respective portions of the body part (8) is being respective flat surfaces of the body part (8). Each of the receiving portions (14, 15) are provided on a vicinity of the respective adhesive elements (18, 19). The flexible portions of the connection members (9, 10) are made from a flexible material which can be bendable. Preferably, the connection members (9, 10) are made from a flexible plastic material. In other words, the first bendable portion (12) can be bent in a first bending direction (W1) towards the first receiving portion (14), and the second bendable portion (13) can be bent in a second bending direction (W2) towards the second receiving portion (15). Furthermore, each of the connection members (9, 10) have knurled portions (16, 17) provided on the bendable portions (12, 13) configured so that the respective bendable portions (12, 13) lock to the respective receiving portions (14, 15). Each of the knurled portions (16, 17) have a plurality of knurls. The knurled portions (16, 17) can be in any shape and size. Preferably, each of the knurls are in a triangular shape. When the knurled portions (16, 17) pass through respective receiving portions (14, 15), firstly an end portion of the relative triangular-shaped knurl enters the receiving portions (14, 15) and then, a flat section of the relative triangular-shaped knurl abuts to a respective region of the respective receiving portions (14, 15). With this arrangement, the knurled portions (16, 17) cannot be moved in a reverse direction which is the opposite direction to the respective bending directions (W1, W2). Therefore, locking the respective bendable portions (12, 13) to the respective receiving portions (14, 15), are provided. Also the loop portions are provided for each electrical cables (6, 7). With the present invention, as can be seen in Fig.5, the electromagnetic waves (EW) which is radiated from the first electrical cable (6) to the second electrical cable (7) is reduced. As can be seen in Fig.6, a higher current (HW) flows in the first electrical cable (6) and a lower current (LW) flows in the second electrical cable (7). With the invention, the electromagnetic compatibility (EMC) between the electrical cables (6, 7) is improved. Also affecting of the operations of the electrical components (20) such as a damper or a fan motor negatively is prevented.

The present invention also relates to a method for arranging two electrical cables (6, 7) in the predetermined distance (D) by means of the cable arranging element (21). The method comprises the steps of:
- providing a cable arranging element (21) having a body part (8) and two connection members (9, 10) by adhering each of the connection members (9, 10) to the respective portions of the body part (8),
- laying the first electrical cable (6) onto the first connection member (9),
- laying the second electrical cable (7) onto the second connection member (10),
- moving the bendable portions (12, 13) of each connection members (9, 10) towards the respective receiving portions (14, 15) in such a way that the bendable portions (12, 13) passes through the respective receiving portions (14, 15) in order to provide loop portions through which the respective electrical cables (6, 7) pass,
- stopping the movement of the bendable portions (12, 13) when the loop portions are provided for each respective electrical cables (6, 7).
After the above-mentioned method steps followed, in order to fill the gap between the rear wall of the cabinet (4) and the outer wall (23) with an insulating material (ie. polyurethane), a foaming process can be followed. With the foaming process, whole the gap including loop portions can be filled with the insulating material.

### Reference List

1. Household appliance
2. Heat-insulating housing
3. Door
4. Cabinet
5. Internal space
6. First electrical cable
7. Second electrical cable
8. Body part
9. First connection member
10. Second connection member
11. Wall surface
12. First bendable portion
13. Second bendable portion
14. First receiving portion
15. Second receiving portion
16. First knurled portion
17. Second knurled portion
18. First adhesive element
19. Second adhesive element
20. Electrical component
21. Cable arranging element
22. Control unit
23. Outer wall
24. Front opening
W1. First bending direction
W2. Second bending direction
D. Predetermined distance
EW. Electromagnetic waves
HW. Higher current
LW. Lower current

## Claims

1. A household appliance (1), particularly a cooling appliance, comprising a heat-insulating housing (2) having an outer wall (23) facing outside, a cabinet (4) enclosing an internal space (5), a control unit (22) for controlling at least one operation in internal space (5) by means of at least one first electrical cable (6) through which an alternating current flows, and at least one second electrical cable (7) through which a direct current flows, **characterized in that** a cable arranging element (21) is provided on a wall surface (11) of the cabinet (4) facing the outer wall (23) in such a way that the first electrical cable (6) and the second electrical cable (7) are being in a predetermined distance (D).

2. The household appliance (1) according to claim 1, **wherein** the wall surface (11) is being a surface of a rear wall of the cabinet (4) which is at an opposite side of a front opening (24) providing access to the internal space (5).

3. The household appliance (1) according to claim 1 or 2, **wherein** the cable arranging element (21) comprises a body part (8) and two connection members (9, 10) provided on the body part (8) mutually.

4. The household appliance (1) according to claim 3, **wherein** an adhesive element (18, 19) is provided so as to connect each of the connection members (9, 10) to the body part (8).

5. The household appliance (1) according to claim 4, **wherein** the adhesive element (18, 19) is being a double-sided tape provided between the respective portions of the body part (8) and the respective connection members (9, 10).

6. The household appliance (1) according to any one of the claim 3 to 5, **wherein** each of the connection members (9, 10) comprise a bendable portion (12, 13) which can be movable between a first position in which the each bendable portions (12, 13) extend in a direction away from the body part (8), and a second position in which the bendable portions (12, 13) pass through the respective receiving portions (14, 15) of the respective connection members (9, 10) so as to provide a loop portion through which the respective electrical cables (6, 7) pass.

7. The household appliance (1) according to claim 6, **wherein** each of the connection members (9, 10) have a knurled portion (16, 17) provided on the bendable portions (12, 13) configured so that the respective bendable portions (12, 13) lock to the respective receiving portions (14, 15).

8. The household appliance (1) according to any one of the claims 4 to 7, **wherein** each of the receiving portions (14, 15) are provided on a vicinity of the respective adhesive elements (18, 19).

9. The household appliance (1) according to any one of the preceding claims, **wherein** the predetermined distance (D) provided between the first electrical cable (6) and the second electrical cable (7) is at least 7 mm, preferably at least 10 mm.

10. The household appliance (1) according to any one of the preceding claims, **wherein** a plurality of cable arranging elements (21) are provided between the electrical cables (6, 7), intermittently with each other on the cabinet (4).

11. A method for arranging two electrical cables (6, 7) of a household appliance (1) in a predetermined distance (D) by means of a cable arranging element (21) according to claim 1, **characterized in that** the method comprises the steps of:
- providing a cable arranging element (21) having a body part (8) and two connection members (9, 10) by adhering each of the connection members (9, 10) to the respective portions of the body part (8),
- laying the first electrical cable (6) onto the first connection member (9),
- laying the second electrical cable (7) onto the second connection member (10),
- moving the bendable portions (12, 13) of each connection members (9, 10) towards the respective receiving portions (14, 15) in such a way that the bendable portions (12, 13) passes through the respective receiving portions (14, 15) in order to provide loop portions through which the respective electrical cables (6, 7) pass,
- stopping the movement of the bendable portions (12, 13) when the loop portions are provided for each respective electrical cables (6, 7).
